# DEMANDE DE BREVET EUROPEEN

(11) **EP 3 208 854 A1**
(43) Date de publication de la demande: **23.08.2017**
(21) Numéro de dépôt: 17156133.5
(22) Date de dépôt: 14.02.2017
(51) Int. Cl.: H01L 31/103, H01L 31/0352, H01L 31/0296, H01L 31/18

(54) **STRUCTURE DE TYPE PHOTODIODE, COMPOSANT ET PROCÉDÉ DE FABRICATION D'UNE STRUCTURE**

(30) Priorité: 18.02.2016 FR 1600270
(71) Demandeur: COMMISSARIAT À L'ÉNERGIE ATOMIQUE ET AUX ÉNERGIES ALTERNATIVES, 75015 Paris (FR)
(72) Inventeur: BOULARD, François, 38000 GRENOBLE (FR); BADANO, Giacomo, 38250 LANS EN VERCORS (FR); GRAVRAND, Olivier, 38120 FONTANIL CORNILLON (FR)
(74) Mandataire: Brevalex

(57) **Abrégé**

L'invention concerne une structure (1) du type photodiode comportant : un support (100) comprenant au moins une couche semiconductrice, la couche semiconductrice (120) comprenant une première zone semiconductrice (10) d'un premier type de conductivité et, une mésa (130) en contact avec la couche semiconductrice (120). La mésa (130) comprend une deuxième zone semiconductrice (20), dite d'absorption, ladite deuxième zone semiconductrice (20) étant d'un deuxième type de conductivité. La deuxième zone semiconductrice présente une concentration en porteurs majoritaires telle que la deuxième zone semiconductrice (20) soit déplétée en l'absence de polarisation de la structure (1). La structure (1) comporte en outre une troisième zone semiconductrice (30) du deuxième type de conductivité réalisée dans un troisième matériau transparent dans la gamme de longueurs d'onde absorbée. La troisième zone (30) semiconductrice s'interpose entre la première et la deuxième zone semiconductrice (10, 20) en étant au moins partiellement agencée dans la couche semiconductrice (120). L'invention concerne également un composant et un procédé de fabrication d'une telle structure (1).

## Description

### DOMAINE TECHNIQUE

L'invention concerne les photodiodes et a plus précisément pour objet les photodiodes adaptées pour détecter et/ou mesurer des rayonnements électromagnétiques dans la gamme des infrarouges.

L'invention se rapporte plus particulièrement à une structure semiconductrice de type photodiode, à un composant semiconducteur comportant au moins une telle structure et à un procédé de fabrication d'une telle structure.

### ÉTAT DE LA TECHNIQUE ANTÉRIEURE

Les structures semiconductrices de type photodiode comprennent généralement un support semiconducteur dans lequel sont ménagées une première et une seconde zone semiconductrice en contact l'une de l'autre et présentant respectivement un premier et un second type de conductivité opposé l'un de l'autre. De cette manière la première et la seconde zone forment ensemble, au niveau de leur contact, une jonction semiconductrice.

Ainsi, en polarisant la jonction en inverse au moyen d'une polarisation externe, lorsqu'un photon, ayant une énergie supérieure à celle de la bande interdite du matériau semiconducteur, pénètre la jonction semiconductrice, celui-ci va générer une paire électron-trou et donc un courant dans la jonction. Ce courant, étant directement proportionnel au rayonnement électromagnétique, il fournit une mesure de ce même rayonnement électromagnétique.

Si une telle technologie est bien adaptée pour la détection et la mesure de rayonnements électromagnétiques, elle possède néanmoins l'inconvénient de présenter un courant d'obscurité non nul, ce qui participe à dégrader le rapport signal sur bruit d'une telle structure. Le courant d'obscurité a pour origine la génération de paires électron-trou non photo-générées dans la structure. Or cette génération a aussi lieu dans la zone active de la structure dans laquelle les photons sont absorbés pour générer le signal. Cette zone, pour maximiser le signal, doit occuper une grande partie du volume de la structure. Elle s'étend généralement sur la quasi-totalité de la surface de la structure, et est donc à l'origine d'un courant d'obscurité important.

Ceci est d'autant plus vrai pour les structures adaptées pour fonctionner dans les longueurs d'onde infrarouges, ces dernières étant sujettes à un bruit important en raison de la faible largeur de bande interdite du matériau dans lequel elles sont formées. En effet, une faible largeur de bande interdite favorise la formation d'un courant d'obscurité d'origine thermique dans la zone active. Pour cette raison, les structures adaptées pour fonctionner dans les longueurs d'onde infrarouges sont généralement refroidies.

Pour remédier à cet inconvénient, il est connu de limiter l'absorption le rayonnement électromagnétique à une zone réduite de la structure dans laquelle est ménagée la jonction et donc la zone active. Ainsi, la structure peut recevoir le rayonnement électromagnétique sur une surface importante sans pour autant nécessiter une zone active occupant un volume important.

C'est cette possibilité qui est exploitée par K. Jóźwikowski et ses co-auteurs dans le cadre de leurs travaux publiés dans la revue scientifique « Journal of Electronic Materials » Volume 38 numéro 8 pages 1666 à 1676 le 24 mars 2009. En effet, K. Jóźwikowski et ses co-auteurs présentent dans cet article une structure semiconductrice dans laquelle la zone active est incluse dans une mésa.

Cette structure comporte :
- un support incluant une couche semiconductrice dans laquelle est partiellement ménagée une première zone semiconductrice d'un premier type de conductivité et réalisée dans un matériau présentant une largeur de bande interdite telle que la première zone semiconductrice est transparente dans une première gamme de longueurs d'onde,
- une mésa, la mésa comportant une deuxième partie de la première zone et une deuxième zone semiconductrice d'un deuxième type de conductivité opposé au premier type de conductivité de manière à former avec la première zone semiconductrice une jonction semiconductrice, la deuxième zone semiconductrice étant réalisée dans un deuxième matériau semiconducteur présentant une largeur de bande interdite adaptée pour favoriser l'absorption du rayonnement électromagnétique, la deuxième zone semiconductrice présentant une concentration en porteurs majoritaires telle que la deuxième zone semiconductrice est comprise dans la zone de charge d'espace, et est donc déplétée, en l'absence de polarisation de la structure.

De cette manière, la zone active de la structure, formée par la deuxième zone semiconductrice, est délimitée par la mésa et présente donc un volume réduit. La génération de courant d'obscurité y est relativement faible. De plus, les phénomènes Auger générateurs de courant d'obscurité nécessitent trois corps, la seconde zone semiconductrice étant configurée pour être déplétée, les phénomènes Auger ne peuvent donc y avoir lieu. Ainsi, une telle structure présente l'avantage de comporter une zone active avec une génération de courant d'obscurité particulièrement faible.

Néanmoins, si une telle structure présente un courant d'obscurité réduit vis-à-vis de l'art antérieur, la première zone et la jonction de cette structure restent à l'origine d'un courant d'obscurité non négligeable. En effet, la jonction intercepte les flancs de mésa qui sont riches en défauts cristallins et peut ainsi être le siège d'une génération de courant d'obscurité relativement important. Un tel courant d'obscurité ne permet pas d'envisager des mesures et/ou détections de rayonnement électromagnétique à des températures « relativement hautes », permettant d'avoir recours à un système de refroidissement allégé.

### EXPOSÉ DE L'INVENTION

L'invention vise à remédier à ces inconvénients et a ainsi pour but de fournir une structure du type photodiode présentant un bruit d'obscurité réduit vis-à-vis des structures de l'art antérieur de manière notamment à autoriser des températures de fonctionnement plus importantes.

L'invention concerne à cet effet une structure du type photodiode destinée à recevoir un rayonnement électromagnétique dans une première gamme de longueurs d'onde, la structure comportant :
- un support comprenant au moins une couche semiconductrice, la couche semiconductrice comprenant une première zone semiconductrice d'un premier type de conductivité et réalisée dans un premier matériau présentant une largeur de bande interdite telle que la première zone semiconductrice est transparente dans la première gamme de longueurs d'onde,
- une mésa en contact avec la couche semidonductrice, la mésa comprenant une deuxième zone semiconductrice, dite d'absorption, ladite deuxième zone semiconductrice étant d'un deuxième type de conductivité opposé au premier type de conductivité de manière à former une jonction semiconductrice présentant une zone de charge d'espace, la deuxième zone semiconductrice étant réalisée dans un deuxième matériau semiconducteur présentant une largeur de bande interdite adaptée pour favoriser l'absorption du rayonnement électromagnétique, la deuxième zone semiconductrice présentant une concentration en porteurs majoritaires telle que la deuxième zone semiconductrice est comprise dans la zone de charge d'espace, et est donc déplétée, en l'absence de polarisation de la structure,
la structure comportant en outre une troisième zone semiconductrice du deuxième type de conductivité et réalisée dans un troisième matériau présentant une largeur de bande interdite telle que la troisième zone est transparente dans la première gamme de longueurs d'onde, ladite troisième zone semiconductrice s'interposant entre la première et la deuxième zone semiconductrice en étant au moins partiellement agencée dans la couche semiconductrice et en formant la jonction semiconductrice avec la première zone semiconductrice dans la couche semiconductrice, et une barrière de potentiel pour les porteurs minoritaires de la deuxième zone semiconductrice avec la deuxième zone semiconductrice.

Avec une telle structure, il est possible d'avoir une zone d'absorption, la deuxième zone semiconductrice, peu sujette à un courant d'obscurité, ceci en raison de son caractère déplétée et de sa délimitation par la mésa, tout en assurant que la jonction ne soit pas elle-même génératrice de courant d'obscurité. En effet, l'ajout de la troisième zone semiconductrice permet de former la jonction dans la couche semiconductrice à distance des défauts se trouvant au niveau des flancs de la mésa qui sont générateurs de courant d'obscurité. Le courant d'obscurité généré par la jonction est réduit vis-à-vis des structures de l'art antérieur.

De plus la zone d'absorption, la deuxième zone, étant déplétée, la collection des porteurs photogénérés dans cette dernière se fait par dérive et non pas par diffusion. Il en résulte une réponse de la structure particulièrement reproductible, ce qui la rend compatible avec une procédure d'étalonnage lors de la procédure de fabrication de la structure, et une faible concentration en défaut dans la zone d'absorption, ce qui laisse entrevoir une réduction du bruit de la structure.

On entend ci-dessus et dans le reste de ce document par zone semiconductrice déplétée le fait que cette dernière zone ait été vidée de ces porteurs en raison du champ électrique présent dans la structure, de telles zones semiconductrices déplétées étant généralement associées à une zone de charge d'espace de la structure.

On entend ci-dessus et dans le reste de ce document par mésa, une région semiconductrice faisant saillie d'un support ou d'une couche semiconductrice, une telle région logeant une partie fonctionnelle d'une structure semiconductrice afin de l'isoler du reste de la structure semiconductrice, ladite partie fonctionnelle étant reliée au reste de la structure uniquement par la base de la mésa. Une telle mésa présente généralement une hauteur, selon une direction transversale à la surface du support ou de la couche semiconductrice, et des dimensions latérales selon un plan parallèle à la surface du support ou de la couche semiconductrice. La hauteur d'une mésa est généralement au moins inférieure de 2 fois, voire 4 à 10 fois, à la dimension latérale maximale.

Par une troisième zone semiconductrice interposée entre la première et la deuxième zone semiconductrice, il doit être entendu que la troisième zone semiconductrice fait interface entre la première et la deuxième zone semiconductrice. Ainsi, avec une telle configuration, la première et la deuxième zone ne sont pas en contact et la jonction semiconductrice est formée uniquement entre la première et la troisième zone semiconductrice. On peut noter, de plus, qu'avec une telle configuration, la troisième zone semiconductrice étant agencée partiellement dans la couche semiconductrice, la jonction est formée dans la couche semiconductrice à distance de la mésa. Bien entendu, une telle interposition de la troisième zone semiconductrice entre la première et la deuxième zone semiconductrice n'exclut pas la présence d'autre élément de la structure entre la première et la deuxième zone semiconductrice, tant que l'interface entre la première et la deuxième zone comprend la troisième zone semiconductrice. Il est donc parfaitement envisageable que la structure comprenne entre la troisième et la deuxième zone semiconductrice une couche dite tampon afin d'absorber une partie des contraintes cristallographiques entre la troisième et la deuxième zone semiconductrice.

Le premier et le troisième matériau peuvent être identiques.

De cette manière, l'interface entre la première et la troisième zone semiconductrice est homogène et présente donc peu de défaut cristallin. On limite ainsi le courant d'obscurité qui pourrait être généré à cette interface.

La troisième zone semiconductrice peut être partiellement agencée dans la couche semiconductrice, une partie de la troisième zone semiconductrice étant agencée dans la mésa.

De cette manière, la deuxième zone, c'est-à-dire la zone active de la structure, est particulièrement éloignée de l'interface entre la mésa et la couche semiconductrice qui peut être génératrice de bruit d'obscurité.

La troisième zone semiconductrice peut être totalement agencée dans la couche semiconductrice.

Une telle structure est particulièrement aisée à fabriquer, puisque la mésa peut être formée d'un seul matériau, celui de la deuxième zone semiconductrice.

La mésa peut présenter un sommet, opposé à la surface du support, et des flancs reliant le sommet à la surface du support,
la structure comportant en outre une couche de passivation et un plot de contact métallique en contact avec le sommet de la mésa, la couche de passivation étant agencée pour passiver la surface des flancs et du sommet de la mésa qui n'est pas en contact avec le plot métallique.

Avec une telle passivation, on limite la génération de bruit dans la zone active de la structure, c'est-à-dire la deuxième zone semiconductrice, puisque les flancs de la mésa dans laquelle elle est aménagée sont passivés.

La structure peut comprenant en outre une couche métallique qui avec le plot de contact métallique, recouvre la couche de passivation sur sa partie recouvrant la surface des flancs et du sommet de la mésa.

Une telle couche métallique peut permettre d'améliorer le confinement optique de la mésa et donc de la deuxième zone semiconductrice qu'elle comprend et ainsi améliorer l'absorption du rayonnement électromagnétique puisque ce dernier se retrouve piégé dans la cavité formée par la mésa.

Le premier, le deuxième et le troisième matériau peuvent être des tellurures de mercure cadmium du type CdₓHg₁₋ₓTe avec x compris entre 1 et 0, 0 et 1 exclus.

De cette manière les interfaces entre les première, deuxième et troisième zones semiconductrices peuvent présenter une bonne qualité cristalline, les tellurures de mercure cadmium présentant une faible variation du paramètre de maille avec la proportion x de mercure.

Le premier type de conductivité peut être celui pour lequel les porteurs majoritaires sont les électrons, le deuxième type de conductivité étant celui pour lequel les porteurs majoritaires sont les trous.

La concentration en porteurs majoritaires dans la première zone semiconductrice peut être fournie principalement par des lacunes de mercure Hg.

De cette manière, il est possible d'utiliser un procédé de fabrication

L'invention concerne en outre un composant pour la détection et/ou la mesure d'un rayonnement électromagnétique dans une gamme de longueurs d'onde donnée, ledit composant comportant une pluralité de structures du type photodiode, le composant comportant au moins une structure selon l'invention.

Un tel composant bénéficier des avantages liés à l'au moins une structure selon l'invention qu'il comporte.

L'invention concerne en outre un procédé de fabrication d'une structure semiconductrice du type photodiode destinée à recevoir un rayonnement électromagnétique dans une gamme de longueurs d'onde donnée, le procédé comportant les étapes suivantes de :
- fourniture d'un support semiconducteur comportant au moins une couche semiconductrice,
- formation d'une mésa en surface de la couche semiconductrice,
- aménagement dans la couche semiconductrice et dans la mésa, d'une première, une deuxième et une troisième zone semiconductrice, la première zone étant aménagée dans la couche semiconductrice et étant d'un premier type de conductivité et réalisée dans un premier matériau présentant une largeur de bande interdite telle que la première zone semiconductrice est transparente dans la première gamme de longueurs d'onde, la deuxième zone semiconductrice étant d'un deuxième type de conductivité opposé au premier type de conductivité de manière à former une jonction semiconductrice présentant une zone de charge d'espace, la deuxième zone semiconductrice étant réalisée dans un deuxième matériau semiconducteur présentant une largeur de bande interdite adaptée pour favoriser l'absorption du rayonnement électromagnétique, la deuxième zone semiconductrice présentant une concentration en porteurs majoritaires telle que la deuxième zone semiconductrice est comprise dans la zone de charge d'espace, et est donc déplétée en l'absence de polarisation de la structure, la troisième zone semiconductrice étant du deuxième type de conductivité et réalisée dans un troisième matériau présentant une largeur de bande interdite telle que la troisième zone est transparente dans la première gamme de longueurs d'onde, ladite troisième zone semiconductrice étant interposée entre la première et la deuxième zone semiconductrice en étant au moins partiellement agencée dans la couche semiconductrice et en formant la jonction semiconductrice avec la première zone semiconductrice dans la couche semiconductrice, et une barrière de potentiel pour les porteurs minoritaires de la deuxième zone semiconductrice avec la deuxième zone semiconductrice.

Un tel procédé permet la fabrication d'une structure selon l'invention et donc de bénéficier des avantages qui y sont liés.

Lors de l'étape de fourniture du support, la couche semiconductrice peut être réalisée dans un tellurure de mercure cadmium du type CdₓHg₁₋ₓTe, avec x compris entre 0 et 1, 0 et 1 exclus, et peut présenter le premier type de conductivité, le premier type de conductivité étant celui dans lequel les porteurs majoritaires sont des trous, les porteurs majoritaires dans la couche semiconductrice étant principalement fournis par des lacunes de mercure Hg
l'étape d'aménagement des première, deuxième et troisième zone semiconductrice pouvant comprendre une sous-étape de diffusion de mercure dans une partie de la couche semiconductrice de manière à venir remplir les lacunes de mercure Hg et neutraliser les trous pour inverser le type de conductivité dans ladite partie de la couche semiconductrice et ainsi former la troisième zone semiconductrice, le reste de la couche semiconductrice formant alors la deuxième zone semiconductrice.

De cette manière, il est possible de former la troisième zone semiconductrice aisément, puisque celle-ci est simplement formée par une neutralisation des lacunes de mercure.

Lors de l'étape d'aménagement des première, deuxième et troisième zone semiconductrice, la sous-étape de diffusion peut consister en une étape d'implantation ionique de la mésa adaptée pour libérer du mercure Hg.

Lors de l'étape d'aménagement des première, deuxième et troisième zone semiconductrice, la sous-étape de diffusion peut consister en une étape de gravure partielle de la mésa adaptée pour libérer du mercure Hg.

Lors de l'étape d'aménagement des première, deuxième et troisième zone semiconductrice, la sous-étape de diffusion peut consister en une étape de diffusion thermique de mercure dans la mésa.

De telles étapes d'aménagement sont particulièrement adaptées pour fournir une structure selon l'invention avec une qualité cristalline entre la première et la deuxième zone préservée puisque l'aménagement de la troisième zone est obtenu par une simple diffusion de mercure.

Plus spécifiquement, lorsque l'invention concerne une structure dont le premier, deuxième et troisièmes matériaux sont des tellurures de mercure cadmium du type CdₓHg₁₋ₓTe avec x compris entre 1 et 0, 0 et 1 exclus, le premier et troisième matériaux étant identiques et le type de conductivité du premier matériau étant fourni par des lacunes de mercure, l'invention concerne plus spécifiquement :
- tout d'abord un procédé de fabrication d'une structure semiconductrice du type photodiode destinée à recevoir un rayonnement électromagnétique dans une gamme de longueurs d'onde donnée, le procédé comportant les étapes suivantes de :
   - fourniture d'un support semiconducteur comportant au moins une couche semiconductrice, la couche semiconductrice étant formée d'un premier matériau présentant une largeur de bande interdite telle que la couche semiconductrice est transparente dans la première gamme de longueurs d'onde,
   - formation d'une mésa en surface de la couche semiconductrice, la mésa comprenant un deuxième matériau semiconducteur présentant une largeur de bande interdite adaptée pour favoriser l'absorption du rayonnement électromagnétique, le reste de la mésa étant réalisé dans le premier matériau,
   - gravure sèche d'une partie du mésa de manière libérer du mercure Hg et engendrer une migration du mercure Hg ainsi libéré de manière à venir combler les lacunes de mercures du premier matériau pour en modifier le type de conductivité du premier type vers le deuxième type de conductivité et ainsi formée au moins partiellement une troisième zone semiconductrice dans la couche semiconductrice, ladite migration de mercure permettant ainsi un aménagement dans la couche semiconductrice et dans la mésa, d'une première, une deuxième et une troisième zone semiconductrice, la première zone correspondant à la zone de la couche semiconductrice libre de migration de mercure, la deuxième zone correspondant au deuxième matériau semiconducteur de la mésa, la troisième zone semiconductrice comportant la zone de la couche semiconductrice dans laquelle le mercure a migré et s'interposant entre la première et la deuxième zone semiconductrice, la troisième zone semiconductrice formant avec la première zone semiconductrice une jonction semiconductrice présentant une zone de charge d'espace, la deuxième zone semiconductrice présentant une concentration en porteurs majoritaires telle que la deuxième zone semiconductrice est comprise dans la zone de charge d'espace, et est donc déplétée en l'absence de polarisation de la structure, la troisième zone semiconductrice étant du deuxième type de conductivité et formant la jonction semiconductrice avec la première zone semiconductrice dans la couche semiconductrice, et une barrière de potentiel pour les porteurs minoritaires de la deuxième zone semiconductrice avec la deuxième zone semiconductrice.
- puis un procédé de fabrication d'une structure semiconductrice du type photodiode destinée à recevoir un rayonnement électromagnétique dans une gamme de longueurs d'onde donnée, le procédé comportant les étapes suivantes de :
   - fourniture d'un support semiconducteur comportant au moins une couche semiconductrice, la couche semiconductrice étant formée d'un premier matériau présentant une largeur de bande interdite telle que la couche semiconductrice est transparente dans la première gamme de longueurs d'onde,
   - formation d'une mésa en surface de la couche semiconductrice, la mésa comprenant un deuxième matériau semiconducteur présentant une largeur de bande interdite adaptée pour favoriser l'absorption du rayonnement électromagnétique, le reste de la mésa étant réalisé dans le premier matériau,
   - implantation ionique d'une partie du mésa de manière libérer du mercure Hg et engendrer une migration du mercure Hg ainsi libéré de manière à venir combler les lacunes de mercures du premier matériau pour en modifier le type de conductivité du premier type vers le deuxième type de conductivité et ainsi formée au moins partiellement une troisième zone semiconductrice dans la couche semiconductrice, ladite migration de mercure permettant ainsi un aménagement dans la couche semiconductrice et dans la mésa, d'une première, une deuxième et une troisième zone semiconductrice, la première zone correspondant à la zone de la couche semiconductrice libre de migration de mercure, la deuxième zone correspondant au deuxième matériau semiconducteur de la mésa, la troisième zone semiconductrice comportant la zone de la couche semiconductrice dans laquelle le mercure a migré et s'interposant entre la première et la deuxième zone semiconductrice, la troisième zone semiconductrice formant avec la première zone semiconductrice une jonction semiconductrice présentant une zone de charge d'espace, la deuxième zone semiconductrice présentant une concentration en porteurs majoritaires telle que la deuxième zone semiconductrice est comprise dans la zone de charge d'espace, et est donc déplétée en l'absence de polarisation de la structure, la troisième zone semiconductrice étant du deuxième type de conductivité et formant la jonction semiconductrice avec la première zone semiconductrice dans la couche semiconductrice, et une barrière de potentiel pour les porteurs minoritaires de la deuxième zone semiconductrice avec la deuxième zone semiconductrice,
- et enfin un procédé de fabrication d'une structure semiconductrice du type photodiode destinée à recevoir un rayonnement électromagnétique dans une gamme de longueurs d'onde donnée, le procédé comportant les étapes suivantes de :
   - fourniture d'un support semiconducteur comportant au moins une couche semiconductrice, la couche semiconductrice étant formée d'un premier matériau présentant une largeur de bande interdite telle que la couche semiconductrice est transparente dans la première gamme de longueurs d'onde,
   - formation d'une mésa en surface de la couche semiconductrice, la mésa comprenant un deuxième matériau semiconducteur présentant une largeur de bande interdite adaptée pour favoriser l'absorption du rayonnement électromagnétique, le reste de la mésa étant réalisé dans le premier matériau,
   - diffusion thermique de mercure Hg dans la couche semiconductrice à partir de la mésa de manière à venir combler les lacunes de mercures du premier matériau pour en modifier le type de conductivité du premier type vers le deuxième type de conductivité et ainsi formée au moins partiellement une troisième zone semiconductrice dans la couche semiconductrice, ladite diffusion de mercure permettant ainsi un aménagement dans la couche semiconductrice et dans la mésa, d'une première, une deuxième et une troisième zone semiconductrice, la première zone correspondant à la zone de la couche semiconductrice libre de migration de mercure, la deuxième zone correspondant au deuxième matériau semiconducteur de la mésa, la troisième zone semiconductrice comportant la zone de la couche semiconductrice dans laquelle le mercure a migré et s'interposant entre la première et la deuxième zone semiconductrice, la troisième zone semiconductrice formant avec la première zone semiconductrice une jonction semiconductrice présentant une zone de charge d'espace, la deuxième zone semiconductrice présentant une concentration en porteurs majoritaires telle que la deuxième zone semiconductrice est comprise dans la zone de charge d'espace, et est donc déplétée en l'absence de polarisation de la structure, la troisième zone semiconductrice étant du deuxième type de conductivité et formant la jonction semiconductrice avec la première zone semiconductrice dans la couche semiconductrice, et une barrière de potentiel pour les porteurs minoritaires de la deuxième zone semiconductrice avec la deuxième zone semiconductrice.

Ces procédés de fabrication de l'invention permettent, en bénéficiant des spécificités des tellurures de mercure-cadmium, d'obtenir une structure selon l'invention avec un minimum d'étapes et en présentant des interfaces entre les première, deuxième et troisième zones semiconductrices de bonne qualité cristalline.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

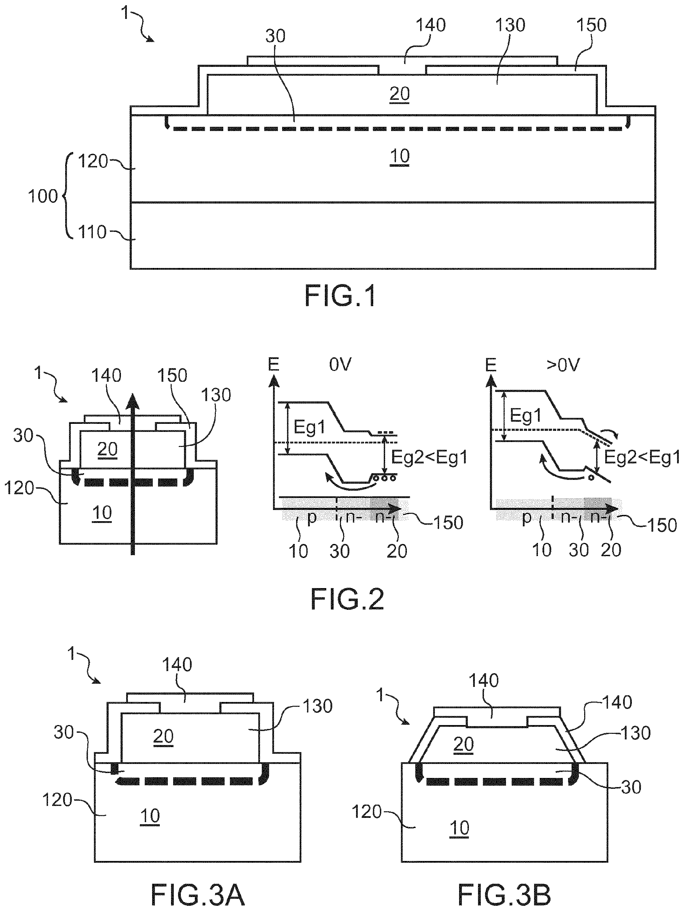

- la figure 1 est une vue en coupe schématique d'une structure selon l'invention,
- la figure 2 illustre schématiquement de gauche à droite la vue de la figure 1 réduite sur laquelle est figurée une direction principale de la structure, un diagramme de bande de la structure en l'absence de polarisation le long de la direction principale et un diagramme de bande de la structure sous polarisation le long de cette même direction,
- les figures 3A et 3B illustrent deux conformations de mésa compatibles avec l'invention, la figure 3A correspondant à une mésa à flancs verticaux, la figure 3B correspondant à une mésa à flancs obliques.

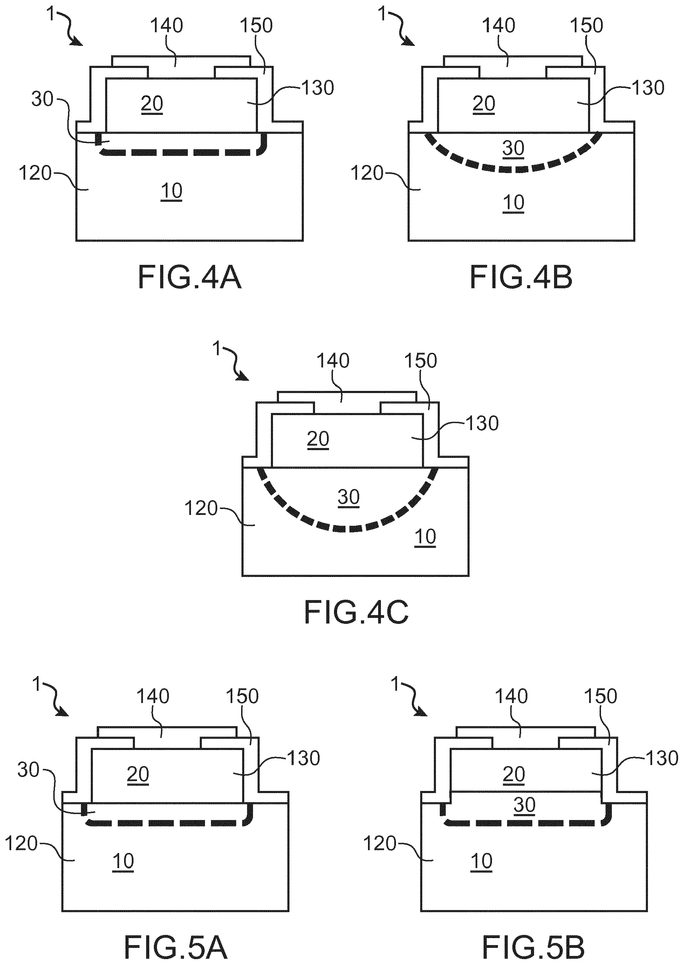

- les figures 4A à 4C illustrent schématiquement les structures selon l'invention obtenues à partir de trois procédés de fabrication selon l'invention, la figure 4A illustrant une structure obtenue au moyen d'une implantation ionique, la figure 4B illustrant une structure obtenue au moyen d'une gravure sèche et la figure 4C illustrant une structure obtenue au moyen d'une diffusion localisée,
- les figure 5A et 5B sont des vues en coupe schématiques d'une première et deuxième possibilité de l'invention, la structure comportant une mésa qui, dans la première possibilité inclut uniquement la deuxième zone semiconductrice de la structure et dans la deuxième possibilité inclut la deuxième zone semiconductrice et une partie de la troisième zone semiconductrice,

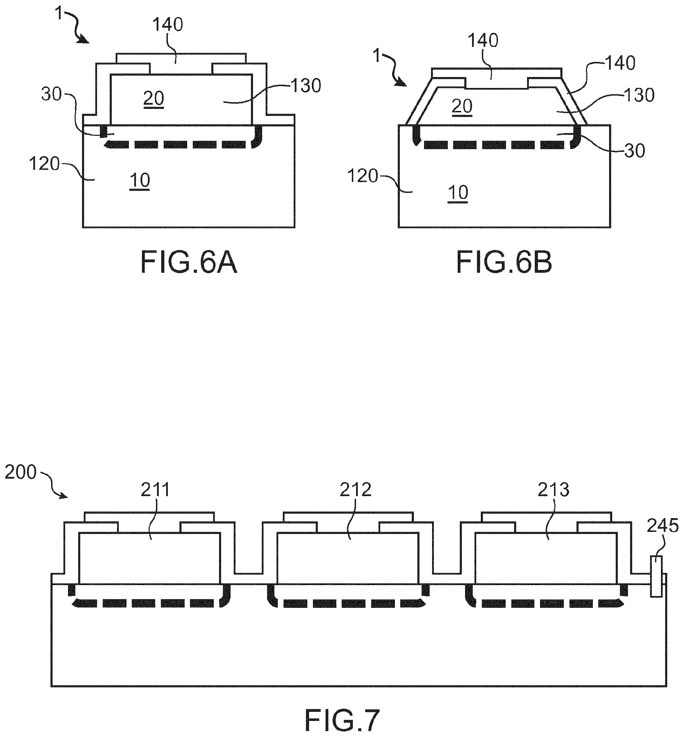

- les figures 6A et 6B illustrent deux possibilités de contact supérieur de l'invention, la figure 6A correspondant à la possibilité de contact simple, la figure 6B correspondant à une possibilité de l'invention dans laquelle le contact supérieur fait également office de miroir pour concentrer le rayonnement électromagnétique,
- la figure 7 illustre un exemple de composant comportant plusieurs structures selon l'invention réparties sous forme d'une matrice.

Des parties identiques, similaires ou équivalentes des différentes figures portent les mêmes références numériques de façon à faciliter le passage d'une figure à l'autre.

Les différentes parties représentées sur les figures ne sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La figure 1 est une vue en coupe schématique d'une structure selon l'invention adaptée pour détecter et/ou mesurer un rayonnement électromagnétique dans une gamme de longueurs d'onde donnée.

La structure selon l'invention est plus particulièrement dédiée à la détection et/ou la mesure de rayonnement dans une gamme de longueurs d'onde comprise dans la gamme des infrarouges. On notera que la gamme des infrarouges est divisée en trois sous-domaines que sont la gamme du proche infrarouge comprise entre 1 et 3 µm, la gamme de l'infrarouge moyen comprise entre 3 et 5 µm et l'infrarouge lointain correspondant aux longueurs d'onde comprises entre 8 et 14 µm. Lors de la conception des structures décrites dans les modes de réalisation suivants, le choix du matériau a porté sur les tellurures de mercure-cadmium du type CdₓHg₁₋ₓTe. Selon le mode de réalisation décrit ci-dessous, le premier type de conductivité correspond au type de conductivité pour lequel les porteurs majoritaires sont les électrons, c'est-à-dire au dopage N, tandis que le deuxième type de conductivité correspond au type de conductivité pour lequel les porteurs majoritaires sont les trous, c'est-à-dire au dopage P. Bien entendu, le premier et le deuxième type de conductivité peuvent être inversés sans que l'on sorte du cadre de l'invention.

La terminologie de « tellurure de mercure-cadmium » utilisée ci-dessus, et dans le reste de ce document, doit être entendue comme correspondant aux composés comprenant le tellure et au moins un élément choisi parmi le cadmium et le mercure tel que les composés respectant la formulation suivante CdₓHg₁₋ₓTe avec la valeur x correspondant à la proportion de cadmium Cd par rapport au mercure et est donc comprise entre 1 et 0, 1 et 0 exclus.

Néanmoins, l'invention ne se limite pas aux seules structures réalisées à partir des tellurures de mercure-cadmium et englobe également tout type de structures dont la conception permet d'obtenir une absorption et une photogénération de porteurs. Ainsi, si dans les modes de réalisation décrits par la suite les différentes zones semiconductrices sont réalisées dans des tellurures de mercure-cadmium, l'homme du métier peut aisément, sur la base du présent enseignement, fournir des structures selon l'invention dont les zones semiconductrice seraient réalisées par exemple dans des arséniures-antimoniures d'indium du type InAs₁₋ₓ Sbₓ, ou encore dans des arséniures d'indium et de gallium du type In₁₋ₓGaₓAs.

La terminologie d'« arséniure-antimoniure d'indium» utilisée ci-dessus, et dans le reste de ce document, doit être entendue comme correspondant aux composés comprenant l'indium et au moins un élément choisi parmi l'arsenic et l'antimoine tels que les composés respectant la formulation suivante InAs₁₋ₓ Sbₓ avec la valeur x correspondant à la proportion d'antimoine par rapport à l'arsenic et est donc comprise entre 1 et 0, 1 et 0 inclus.

La terminologie d'« arséniures d'indium et de gallium » utilisée ci-dessus et dans le reste de ce document doit être entendue comme correspondant aux composés comprenant l'arsenic et au moins un élément choisi parmi l'indium et le gallium tels que les composés respectant la formulation suivante in₁₋ₓGaₓAs avec la valeur x correspondant à la proportion de gallium par rapport à l'indium et est donc comprise entre 1 et 0, 1 et 0 inclus.

De plus, si la structure 1 présente des zones semiconductrices réalisées dans un seul type de matériau tels que les tellurures de mercure cadmium et les arséniures-antimoniures d'indium, il est également envisageable qu'une structure selon l'invention présente des zones semiconductrices réalisées dans plusieurs types de matériaux et ceci notamment par la présence d'un substrat 110 dans un matériau d'un autre type. Ainsi par exemple, une structure présentant ses zones « fonctionnelles » réalisées dans des tellurures de mercure-cadmium peut comporter un support réalisé en tellurure zinc-cadmium du type Cd_{1-y}Zn_{y}Te avec y la proportion de zinc comprise entre 1 et 0,1 et 0 exclus.

Une telle structure 1 comporte :
- un support 100 comprenant au moins une couche semiconductrice 120,
- une mésa 130 en contact avec la couche semiconductrice 120.

Le support 100 et sa couche semiconductrice 120 sont choisis comme étant constitués de matériaux transparents dans la gamme de longueurs d'onde donnée.

Ainsi, le support semiconducteur peut être constitué d'un substrat 110 isolant de tellurure de zinc-cadmium sur lequel a été déposé une couche semiconductrice de tellurure de mercure-cadmium du type CdₓHg₁₋ₓTe avec la valeur x de la proportion de cadmium suffisamment importante pour que la couche semiconductrice soit transparente dans la gamme de longueurs d'onde donnée. La proportion x de cadmium dans le tellurure de mercure-cadmium de la couche semiconductrice peut être ainsi être choisie comme suit :
- pour une gamme de longueurs d'onde donnée du proche infrarouge, supérieure à 0,40,
- pour une gamme de longueurs d'onde donnée du moyen infrarouge, supérieure à 0,3,
- pour une gamme de longueurs d'onde donnée des infrarouges lointains, supérieure à 0,15.

La proportion en zinc du substrat 110 est préférentiellement choisi de manière à permettre un bon accord de maille avec la couche semiconductrice 120, ceci afin d'obtenir une interface entre le substrat 110 et la couche semiconductrice 120 présentant peu, voire pas, de défauts cristallins et ceci sans couche intermédiaire telle qu'une couche « tampon ».

Bien entendu, il est également envisageable, sans que l'on sorte du cadre de l'invention, que le support comporte en outre, entre le substrat 110 et la couche semiconductrice, une couche dite tampon adaptée pour absorber une partie des contraintes cristallines entre le substrat 110 et la couche semiconductrice 210.

Le substrat 110 présente une première et une deuxième face longitudinale s'entendant chacune parallèlement à un plan principal de la structure 1. La direction transversale au plan principal dirigée du substrat 110 vers la couche semiconductrice 120, est une direction principale de la structure.

La couche semiconductrice 120 comporte une première et une deuxième face, la première face étant en contact avec la deuxième face longitudinale du substrat 110. La couche semiconductrice 120 est en contact sur la surface de sa deuxième face avec la mésa 130.

La couche semiconductrice 120 présente une épaisseur selon la direction principale comprise entre 1 et 15 µm, typiquement de 2 à 4 µm et qui peut être par exemple égale à 3 µm.

La couche semiconductrice 120 comporte une première et une troisième zone semiconductrice 10, 30. La première zone semiconductrice 10 s'étend à partir de la première face de la couche semiconductrice 120, la troisième zone semiconductrice 30 s'étendant à partir de la surface de la deuxième face en contact avec la mésa 130 de manière à s'interposer entre la mésa 130 et la première zone semiconductrice 10.

La première zone semiconductrice 10 est dopée P avec une concentration en porteurs majoritaires compris entre 5.10¹⁵ cm⁻³ et 1.10¹⁸ cm⁻³.

La troisième zone semiconductrice 30 forme une interface entre la mésa 130, et donc une deuxième zone semiconductrice 20 qui y est incluse, et la première zone semiconductrice 10. Son épaisseur est comprise entre 100 nm et 500 nm, voire entre 120 nm et 300 nm, et typiquement de 150 nm.

La troisième zone semiconductrice 30 est dopée N et présente une concentration en porteurs majoritaires comprise entre 10¹⁴ cm⁻³ et 10¹⁶ cm⁻³, cette dernière étant préférentiellement inférieure à celle de la première zone semiconductrice 10. Avec un tel dopage N, la troisième zone semiconductrice 30 forme avec la première zone semiconductrice 10 une jonction semiconductrice, illustrée par une ligne pointillée sur la figure 1, qui est incluse dans la couche semiconductrice 120.

La mésa 130 s'étend à partir de la surface de la deuxième face de la couche semiconductrice 120. La mésa 130 présente selon la direction principale une hauteur et dans un plan transversal à la direction principale, c'est-à-dire le plan principal, au moins une dimension dite largeur. Selon une possibilité avantageuse de l'invention, la hauteur et la largeur de la mésa 130 peuvent être choisies en fonction de la gamme de longueurs d'onde donnée de manière à optimiser l'absorption d'un rayonnement électromagnétique compris dans ladite gamme.

Ainsi dans le cas d'une gamme de longueurs d'onde donnée comprise dans la gamme des infrarouges, la hauteur de la mésa 130 peut être choisie comme suit :
- pour une gamme de longueurs d'onde donnée dans le proche infrarouge, la hauteur de la mésa peut être comprise entre 0,2 µm et µm,
- pour une gamme de longueurs d'onde donnée dans le moyen infrarouge, la hauteur de la mésa peut être comprise entre 0,5 µm et 1,5 µm,
- pour une gamme de longueurs d'onde donnée dans les infrarouges lointains, la hauteur de la mésa peut être comprise entre 0,7 µm et 2,5 µm.

La hauteur de la mésa 130 peut être avantageusement choisie de manière à former une cavité Fabry-Perot verticale, délimitée par le plot de contact de métallique 140 et la couche de passivation 150 et par le contraste d'indice entre la mésa 130 et la couche semiconductrice 120. Cette possibilité est particulièrement avantageuse quand la largeur de la mesa est grande devant les longueurs d'onde de la gamme de longueurs d'onde divisées par l'indice du deuxième matériau.

Si la largeur de la mesa 130 est comparable aux longueurs d'onde de la gamme de longueurs d'onde divisée par l'indice du deuxième matériau , la largeur et la hauteur de la mésa 130 peuvent également être définies de manière à former une cavité optique dans la gamme de longueurs d'onde, selon une possibilité décrite dans le document US 2015/0303320, permettant une plus forte concentration de la lumière incidente dans la cavité optique ainsi formée. Selon cette possibilité, la section de la mésa selon le plan principal peut être circulaire, carrée, voire hexagonale ou rectangulaire, avec des dimensions adaptées pour former une cavité selon l'enseignement du document US 2015/0303320.

En variante, seule la deuxième zone semiconductrice 20 peut être configurée pour former une cavité optique telle que décrite dans document US 2015/0303320. Selon cette variante, les conditions de dimensionnement de la mésa exposées dans les deux paragraphes ci-dessus s'appliquent à la deuxième zone semiconductrice 20.La section de la mésa 130 dans le plan principal peut être dans la direction principale constante, comme illustré sur la figure 3A ou variable, comme illustré sur la figure 3B. Dans le cas où la section de la mésa 130 est variable, cette variation en fonction de la hauteur selon la direction principale est préférentiellement monotone. On notera que dans ce mode de réalisation pour lequel la mésa 130 est réalisée dans un tellurure de mercure-cadmium, la variation de la section de la mésa 130 en fonction de la hauteur selon la direction principale peut être réalisée selon un angle entre les flancs de mésa 130 et la surface de la deuxième face de la couche semiconductrice 120 compris entre 90° et 30°.

La mésa 130 est réalisée dans un tellurure de mercure-cadmium du type CdₓHg₁₋ₓTe avec la valeur x de la proportion de cadmium qui est adaptée pour permettre une absorption d'un rayonnement électromagnétique dans la gamme de longueurs d'onde donnée. Ainsi, la proportion x de cadmium Cd du tellurure de mercure-cadmium dans la mésa 130 peut être choisie comme suit :
- pour une gamme de longueurs d'onde donnée dans le proche infrarouge, la proportion x est comprise entre 0,35 et 0,6,
- pour une gamme de longueurs d'onde donnée dans le moyen infrarouge, la proportion x est comprise entre 0,28 et 0,35,
- pour une gamme de longueurs d'onde donnée dans les infrarouges lointains, la proportion x est comprise entre 0,18 et 0,26.

La mésa 130, et donc la deuxième zone semiconductrice 20 qu'elle forme, sont dopées N. La concentration en porteurs majoritaires dans la mésa 130, et donc dans la deuxième zone semiconductrice 20, est adaptée de manière à ce que la deuxième zone semiconductrice 20 soit comprise dans la zone de charge d'espace, et soit donc déplétée, en l'absence de polarisation de la structure 1. Généralement, une telle condition peut être obtenue avec une concentration en porteurs majoritaires comprise entre 10¹⁴ cm⁻³ et 10¹⁶ cm⁻³.

Bien entendu, pour qu'une telle condition de déplétion de la deuxième zone semiconductrice 20 soit remplie, la concentration en porteurs majoritaires de la mésa, et donc de la deuxième zone semiconductrice 20, est choisie en fonction de la concentration en porteurs majoritaires de la première et de la troisième zone semiconductrice 10, 30. On peut noter que dans la mesure où la deuxième zone semiconductrice 20 est déplétée, la troisième zone semiconductrice 30 l'est également.

Le sommet de la mésa 130, c'est-à-dire la partie de la mésa 130 opposée à la couche semiconductrice 120, est en contact avec un plot de contact métallique 140. La partie du sommet de la mésa 130 qui n'est pas en contact avec un plot de contact métallique 140 et les flancs de la mésa 130, c'est-à-dire les parois latérales de la mésa 130 reliant le sommet de la mésa 130 à la couche semiconductrice 120, sont recouvertes au moyen d'une couche de passivation 150. Autrement dit, la couche de passivation 150 présente une ouverture par laquelle le plot de contact métallique 140 est en contact avec le sommet de la mésa 130. Dans la configuration illustrée sur la figure 1, le plot de contact métallique 140 recouvre avantageusement une portion de la couche de passivation 150 recouvrant le sommet de la mésa 130. Avec une telle configuration, le plot de contact métallique 140 est adapté pour une connexion à un circuit de lecture déporté, non illustré, par hybridation par bille d'indium.

La couche de passivation 150 permet de fournir une délimitation de la deuxième zone semiconductrice 20 parfaitement définie et chimiquement stable.

La couche de passivation 150 peut être réalisée dans un matériau isolant tel qu'un tellurure de cadmium CdTe, un sulfure de zinc ZnS, un dioxyde de silicium SiO₂.

Le plot de contact métallique 140 peut être réalisé dans tout type de métal apte à former un contact ohmique avec la deuxième zone semiconductrice 20. Ainsi le plot de contact métallique peut être réalisé dans un métal sélectionné dans le groupe comportant l'or Au, le titane Ti, le chrome Cr et leur alliage.

On notera que dans la figure 1, ainsi que dans les autres figures du présent document, aucun contact métallique de la première zone semiconductrice 10 n'a été représenté. En effet, les structures selon l'invention étant généralement destinées à équiper des composants dans lesquelles elles sont organisées en matrice, leurs premières zones semiconductrices sont polarisées au moyen d'un contact déporté commun. Ainsi la polarisation de la structure selon l'invention se fait au moyen du plot de contact métallique 140 et d'un contact déporté non illustré sur la figure 1.

Bien entendu, une telle possibilité usuelle de contact déporté commun ne limite en rien la portée de l'invention, l'invention englobant également les structures 1 comportant pour la première zone semiconductrice 10 un contact rapproché et individuel.

Ainsi, avec une telle structure, la jonction semiconductrice se trouvant dans la couche semiconductrice 120, n'intercepte pas une région de la structure 1 présentant une concentration en défauts importants telle que les flancs de la mésa 130. De plus, comme illustré sur la figure 2 par le diagramme de bande qui y est présent en son centre, la troisième zone semiconductrice, en l'absence de polarisation, fait office de barrière de potentiel pour les trous se trouvant dans la bande de valence de la deuxième zone semiconductrice 20. Une telle barrière, néanmoins, comme illustré sur le diagramme de bande de la structure en fonctionnement présent à la droite de la figure 2, ne perturbe pas le fonctionnement de la structure. La structure 1 présente ainsi, un courant d'obscurité faible en fonctionnement qui permet d'envisager des températures de fonctionnement relativement élevées dans ses applications dans la gamme des infrarouges.

Une telle structure 1 peut être fabriquée au moyen d'un procédé de procédé de fabrication comportant les étapes suivantes :
- fourniture du support 100, le support 100 comprenant le substrat 110 et la couche semiconductrice 120,
- formation de la mésa 130 en contact avec la couche semiconductrice 120,
- aménagement de la première, la deuxième et la troisième zone semiconductrice 10, 20,30 dans la couche semiconductrice 120 et la mésa 130,
- dépôt de la couche de passivation 150,
- formation du plot de contact métallique 140.

L'étape de fourniture du support 100 peut comprendre les sous-étapes suivantes :
- fourniture du substrat 110,
- dépôt de la couche semiconductrice 120 en contact avec la deuxième face du substrat 110.

Dans l'étape de fourniture du support, la couche semiconductrice 120 est formée, par exemple par dépôt, en y incluant des éléments dopants accepteurs d'électrons, c'est-à-dire du type P. Dans ce mode de réalisation, dans lequel la couche semiconductrice 120 est réalisée dans un tellurure de mercure-cadmium, les éléments dopants accepteurs d'électrons peuvent être fournis par des éléments dopants en tant que tels, tels que de l'arsenic As, ou par des lacunes de mercure Hg.

On peut également noter que, pendant cette même étape de fourniture du support 100, la couche semiconductrice 120 peut également comporter, de manière intrinsèque ou par implantation, des éléments dopants donneurs d'électrons dont la concentration est plus faible que celle des éléments dopants accepteurs d'électrons. Cette possibilité est particulièrement avantageuse pour la formation de la troisième zone semiconductrice 30 dans la couche semiconductrice 120 puisqu'elle autorise une révélation des éléments dopants donneurs d'électrons par une neutralisation des éléments accepteurs d'électrons, par exemple en remplissant les éventuelles lacunes de mercure Hg.

Ainsi, selon cette possibilité, la couche semiconductrice peut présenter, lors de l'étape de fourniture du support, une concentration en éléments dopants accepteur d'électrons, tels que des lacunes de mercure Hg, correspondant à une concentration en porteurs majoritaires de la première zone semiconductrice 20, et une concentration en éléments dopants donneurs d'électrons, tels que de l'indium In ou de l'iode I, correspondant à une concentration en porteurs majoritaires de la troisième zone semiconductrice 30. Bien entendu, la concentration en porteurs majoritaires dans la deuxième zone semiconductrice 20 étant inférieure à celle en porteurs majoritaires dans la première zone semiconductrice 10, la couche semiconductrice présente, dans ces conditions et avant aménagement des zones semiconductrices 10, 20, 30, un dopage P avec une concentration en porteurs majoritaires correspondant à celle de la deuxième zone semiconductrice 20.

L'étape de formation de la mésa peut comprendre les sous-étapes suivantes :
- dépôt d'une couche semiconductrice supplémentaire, non illustrée, dont la hauteur, selon la direction principale de la structure 1, correspond à la hauteur de mésa 130 recherchée,
- gravure partielle de la couche semiconductrice supplémentaire, une portion de la couche semiconductrice correspondant à la mésa 130 n'étant pas gravée de manière à former la mésa.

La gravure partielle de la couche semiconductrice supplémentaire peut être une étape de gravure par voie humide, c'est-à-dire obtenue au moyen d'une attaque acide.

Que ce soit la sous-étape de dépôt de la couche semiconductrice 120 ou celle de la couche semiconductrice supplémentaire, le dépôt est préférentiellement réalisé par une épitaxie par faisceau moléculaire de manière à fournir des couches semiconductrices de bonne qualité cristalline avec un contrôle précis sur leur composition, notamment concernant la concentration en éléments dopants et donc en porteurs majoritaires.

L'étape d'aménagement de la première, la deuxième et la troisième zone semiconductrice 10, 20 ,30 dans la couche semiconductrice 120 et dans la mésa 130 peut être réalisée de différentes manières.

Ainsi les figures 4A à 4C illustrent trois structures 1 obtenues aux moyens de trois variantes respectives d'aménagement, toutes trois basées sur une étape de fourniture du support 100 dans laquelle la couche semiconductrice 120 comporte une concentration en porteurs majoritaires correspondant à celle de la première zone semiconductrice 10 qui est fournie par la présence de lacunes de mercure Hg.

La structure illustrée sur la figure 4A correspond à une étape d'aménagement dans laquelle la concentration en porteurs majoritaires dans la deuxième et la troisième zone 20, 30 est fournie par implantation ionique d'ions tels que des ions de bore B. une telle implantation d'ions de bore B dans la mésa 130 permet de libérer du mercure Hg et engendre une migration, ou diffusion, du mercure Hg ainsi libéré dans la couche semiconductrice à proximité de la mésa 130. Ce mercure Hg permet de remplir les lacunes en mercure Hg de la couche semiconductrice et d'annuler le dopage P à proximité de la mésa 130 en révélant le dopage N résiduel du tellurure de mercure cadmium. La mésa 130 et une portion de la couche semiconductrice 120 à proximité de mésa présentent ainsi un dopage N et forment donc respectivement la deuxième et la troisième zone semiconductrice 20, 30, tandis que le reste de la couche semiconductrice forme la première zone semiconductrice 10.

La structure 1 illustrée sur la figure 4B correspond à une étape d'aménagement dans laquelle la concentration en porteurs majoritaires dans la deuxième et la troisième zone 20, 30 est fournie par une gravure sèche, par exemple une gravure plasma. Une telle gravure permet, de la même façon que l'implantation ionique, de libérer du mercure Hg et engendre une migration, ou diffusion, du mercure Hg ainsi libéré dans la couche semiconductrice à proximité de la mésa 130. De la même façon que pour l'implantation ionique, cette migration de mercure Hg permet de former les première, deuxième et troisième zones semiconductrices 10, 20, 30. Cette variante d'aménagement présente comme avantage de permettre de fournir une ouverture dans la mésa 130 pour optimiser le contact entre la deuxième zone semiconductrice 20 et le plot de contact métallique 140. En effet, le plot de contact 150 peut être formé dans l'ouverture libérée par la gravure, le contact entre la mésa 130 et le plot de contact 150 se faisant alors sur toute la surface de l'ouverture.

La structure illustrée sur la figure 4C correspond à une étape d'aménagement dans laquelle la concentration en porteurs majoritaires dans la deuxième et la troisième zone 20, 30 est fournie par une diffusion localisée de mercure Hg à partir d'une ouverture ménagée dans la couche de passivation 150. Une telle étape consiste en une étape de traitement thermique sous atmosphère mercure Hg alors que l'ouverture a été préalablement aménagée dans la couche de passivation. Ce traitement thermique permet de faire diffuser du mercure Hg dans la mésa 130 et dans la couche semiconductrice 120 à proximité de la mésa 130. De cette manière et selon le même principe que l'implantation ionique et la gravure, le mercure Hg diffuse et permet de combler les lacunes de mercure Hg et de former les première, deuxième et troisième zones semiconductrices 10, 20, 30. Dans cette troisième variante d'aménagement des première, deuxième et troisième zones semiconductrices 10, 20, 30, c'est cette même ouverture qui est utilisée pour mettre en contact le plot de contact métallique 140 et la mésa 130.

Dans ces trois variantes d'étapes d'aménagement, les conditions de ces étapes, telles que l'énergie d'implantation, la profondeur de gravure et la durée du traitement thermique, permettent de définir la distance de diffusion du mercure Hg et donc, les dimensions de la troisième zone 30 et la position de la jonction semiconductrice.

Bien entendu, si les trois variantes de l'étape d'aménagement permettent un aménagement aisé des première, deuxième et troisième zones semiconductrices 10, 20, 30, il est également possible de fournir l'aménagement des première, deuxième et troisième zones semiconductrices 10, 20, 30 par un procédé d'implantation d'éléments dopants. Si une telle étape d'aménagement demande un aménagement des première, deuxième et troisième zones en plusieurs sous-étapes, l'implantation de la troisième zone devant, par exemple, être effectuée avant l'étape de formation de la mésa, elle présente l'avantage de pouvoir être réalisée quel que soit le type de dopage de la couche semiconductrice 120.

Les figures 5A et 5B illustrent deux possibilités de l'invention concernant le positionnement de la troisième zone 30. En effet, comme décrit ci-dessus dans ce premier mode de réalisation et comme illustré sur la figure 5A, la troisième zone semiconductrice 30 peut être totalement incluse dans la couche semiconductrice.

Néanmoins, dans un deuxième mode de réalisation illustré sur la figure 5B, la troisième zone semiconductrice 30 peut également être partiellement incluse dans la mésa 130. Ainsi cette structure selon ce deuxième mode de réalisation se différencie de la structure 1 selon le premier mode de réalisation en ce que la troisième zone semiconductrice 30 est partiellement incluse dans la mésa, le reste de la troisième zone semiconductrice 30 restant inclus dans la couche semiconductrice 120 à proximité de la mésa 130.

Dans ce deuxième mode de réalisation, la mésa 130 présente la portion de mésa par laquelle elle est en contact avec la couche semiconductrice 120 et qui réalisée dans le même matériau que la couche semiconductrice. Cette portion de mésa est donc transparente dans la gamme de longueurs d'onde donnée. La portion de mésa s'interpose entre la couche semiconductrice 120 et le reste de la mésa 130 formant la deuxième zone semiconductrice.

En d'autres termes, la portion de mésa 120 présente les mêmes caractéristiques que le reste de la troisième zone 30 qui est aménagée dans la couche semiconductrice 120, tandis que le reste de la mésa présente les caractéristiques de la deuxième zone semiconductrice telle que décrite dans le premier mode de réalisation. En particulier, le dimensionnement de la deuxième zone semiconductrice 20 reste identique à celui décrit dans le premier mode de réalisation, la mésa 120 selon ce deuxième mode de réalisation présente donc une hauteur selon la direction principale de la structure 1 plus importante que celle du premier mode de réalisation puisque sa hauteur correspond à l'addition des hauteurs de la portion de mésa et la deuxième zone semiconductrice 20.

La hauteur de la portion de mésa 30 est préférentiellement choisie comme étant inférieure à celle de la deuxième zone semiconductrice 20.

Le procédé de fabrication d'une structure 1 selon ce deuxième mode de réalisation se différencie du procédé de fabrication d'une structure 1 selon le premier mode de réalisation en ce qu'il est prévu une étape de gravure partielle de la couche semiconductrice 120 de manière à former la portion de la mésa. Cette gravure partielle peut être réalisée lors de la gravure partielle de la couche semiconductrice supplémentaire.

On peut également noter, en conformité avec les figures 6A et 6B, que le contact métallique 140 peut également comprendre une couche métallique recouvrant, avec le plot de contact, l'intégralité du sommet et des flancs de la mésa.

En effet, la figure 6A montre la configuration du plot de contact métallique 140 telle que déjà décrite dans le cadre du premier mode de réalisation, une telle configuration étant adaptée pour une connexion par hybridation par bille d'indium à un circuit de lecture déporté. La figure 6B illustre la possibilité selon laquelle le contact métallique comprend, en plus du plot de contact métallique 140, une couche métallique 141 permettant, en complément du plot de contact métallique 140, de recouvrir le sommet et les flancs de la mésa 130.

La figure 6B montre que, de la même façon que dans la configuration décrite en relation du premier mode de réalisation, la couche de passivation 150 présente une ouverture sur le sommet de la mésa 130 par laquelle le plot de contact métallique 140 est en contact avec la mésa 120. Le plot de contact métallique 140 se prolonge pour sa partie recouvrant une portion de la couche de passivation 150, par la couche métallique 141. De cette manière, la mésa 120 est entièrement logée dans une cavité formée par le plot de contact métallique 140 et la couche métallique 141 qui sont réfléchissantes pour le rayonnement électromagnétique. Cela permet ainsi d'augmenter le taux de remplissage optique de la deuxième zone semiconductrice 20 par réflexion du rayonnement électromagnétique entrant dans la mésa 130 sur les flancs de la mésa. Cette possibilité illustrée sur la figure 6B est particulièrement avantageuse dans le cas où la mésa 130 est dimensionnée pour former une cavité Fabry-Pérot.

Les structures 1 des premier et deuxième modes de réalisation, selon les différentes possibilités et variantes décrites ci-dessus, sont particulièrement adaptées pour fournir un composant, tel qu'un photodétecteur, dans lequel elles sont associées en matrice, chacune des structures formant un pixel dudit photodétecteur. La figure 7 permet d'illustrer une telle possibilité de composant 200. Sur cette figure 7, seule trois structures 211, 212, 213 d'une ligne sont représentées, ces structures étant toutes trois identiques à celle illustrée sur la figure 1. La figure 7 montre également la présence d'un contact métallique déporté 245 commun à l'ensemble des structures 211, 212, 213 du composant 200.

On notera également, que les structures selon l'invention, de manière identique à la structure décrite par K. Jóźwikowski et ses co-auteurs, peuvent être associées à un système de concentration optique, tel qu'une lentille, pour concentrer le rayonnement électromagnétique dans la deuxième zone semiconductrice. Une telle possibilité permet de conserver une bonne sensibilité de la structure malgré une zone active, la deuxième zone 20, de dimensions réduites.

Bien entendu, la disposition des première, deuxième et troisième zones semiconductrices 10, 20, 30 décrites dans les modes de réalisation ci-dessus est donnée qu'à titre d'illustration et n'est nullement limitative. Ainsi, l'invention couvre toutes dispositions de ces trois zones semiconductrices 10, 20 ,30, tant que la première zone 10 est aménagée dans une couche semiconductrice 120 du support 100, la troisième zone semiconductrice 30 étant au moins en partie aménagée dans cette même couche semiconductrice 120 pour former la jonction semiconductrice 10 avec la première zone semiconductrice 10 dans la couche semiconductrice 120, et que la deuxième zone semiconductrice 20 est aménagée dans la mésa 130 en formant avec la troisième zone semiconductrice 30 une barrière de potentiel pour les porteurs minoritaires de la deuxième zone semiconductrice 20. Ainsi, l'invention couvre, par exemple, également une troisième zone semiconductrice 30 qui s'étend sur toute l'épaisseur de la couche semiconductrice 120, la deuxième zone semiconductrice 20 se trouvant alors sur le côté de la mésa 130.

## Revendications

1. Structure (1) du type photodiode destinée à recevoir un rayonnement électromagnétique dans une gamme de longueurs d'onde donnée, la structure (1) comportant :
- un support (100) comprenant au moins une couche semiconductrice (120), la couche semiconductrice (120) comprenant une première zone semiconductrice (10) d'un premier type de conductivité réalisée dans un premier matériau présentant une largeur de bande interdite telle que la première zone semiconductrice (10) est transparente dans la gamme de longueurs d'onde,
- une mésa (130) en contact avec la couche semiconductrice (120), la mésa (130) comprenant une deuxième zone semiconductrice (20), dite d'absorption, ladite deuxième zone semiconductrice (20) étant d'un deuxième type de conductivité opposé au premier type de conductivité de manière à former une jonction semiconductrice présentant une zone de charge d'espace, la deuxième zone semiconductrice (20) étant réalisée dans un deuxième matériau semiconducteur présentant une largeur de bande interdite adaptée pour favoriser l'absorption du rayonnement électromagnétique, la deuxième zone semiconductrice présentant une concentration en porteurs majoritaires telle que la deuxième zone semiconductrice (20) est comprise dans la zone de charge d'espace, et est donc déplétée, en l'absence de polarisation de la structure (1),
la structure (1) étant **caractérisée en ce qu'**elle comporte une troisième zone semiconductrice (30) du deuxième type de conductivité réalisée dans un troisième matériau présentant une largeur de bande interdite telle que la troisième zone semiconductrice (30) est transparente dans la gamme de longueurs d'onde, ladite troisième zone semiconductrice (30) étant interposée entre la première et la deuxième zone semiconductrice (10, 20) en étant au moins partiellement agencée dans la couche semiconductrice (120) et en formant la jonction semiconductrice (10) avec la première zone semiconductrice dans la couche semiconductrice (120), dans laquelle, la troisième zone semiconductrice (30) forme avec la deuxième zone semiconductrice(20) une barrière de potentiel pour les porteurs minoritaires de la deuxième zone semiconductrice (20).

2. Structure (1) du type photodiode selon la revendication 1, dans laquelle le premier et le troisième matériau sont identiques.

3. Structure (1) du type photodiode selon la revendication 1 ou 2, dans laquelle la troisième zone semiconductrice (30) est partiellement agencée dans la couche semiconductrice (120), une partie de la troisième zone semiconductrice (30) étant agencée dans la mésa (130).

4. Structure (1) du type photodiode selon la revendication 1 ou 2, dans laquelle la troisième zone semiconductrice (30) est totalement agencée dans la couche semiconductrice (120).

5. Structure (1) du type photodiode selon l'une quelconque des revendications 1 à 4 dans laquelle la mésa (130) présente un sommet, opposé à la surface du support (100), et des flancs reliant le sommet à la surface du support (100),
la structure (1) comportant en outre une couche de passivation et un plot de contact métallique en contact avec le sommet de la mésa, la couche de passivation étant agencée pour passiver la surface des flancs et du sommet de la mésa (130) qui n'est pas en contact avec le plot métallique (150).

6. Structure (1) du type photodiode selon la revendication 5, comprenant en outre une couche métallique (141) qui avec le plot de contact métallique, recouvre la couche de passivation sur sa partie recouvrant la surface des flancs et du sommet de la mésa (130).

7. Structure (1) du type photodiode selon l'une quelconque des revendications 1 à 6, dans laquelle le premier, le deuxième et le troisièmes matériau sont des tellurures de mercure cadmium du type CdₓHg₁₋ₓTe avec x compris entre 1 et 0, 0 et 1 exclus.

8. Structure (1) du type photodiode selon l'une quelconque des revendications 1 à 7, dans laquelle le premier type de conductivité est celui pour lequel les porteurs majoritaires sont les électrons, le deuxième type de conductivité étant celui pour lequel les porteurs majoritaires sont les trous.

9. Structure (1) du type photodiode selon les revendications 7 et 8 prisent en combinaison, dans laquelle la concentration en porteurs majoritaires dans la première zone semiconductrice est fournie principalement par des lacunes de mercure Hg.

10. Composant (200) pour la détection et/ou la mesure d'un rayonnement électromagnétique dans une gamme de longueurs d'onde donnée, ledit composant comportant une pluralité de structures du type photodiode et étant **caractérisé en ce que** au moins l'une des structures du type photodiode de la pluralité de structures du type photodiode est une structure selon l'une quelconque des revendications 1 à 9.

11. Procédé de fabrication d'une structure semiconductrice du type photodiode destinée à recevoir un rayonnement électromagnétique dans une gamme de longueurs d'onde donnée, le procédé comportant les étapes suivantes de :
- fourniture d'un support semiconducteur comportant au moins une couche semiconductrice,
- formation d'une mésa en surface de la couche semiconductrice,
- aménagement dans la couche semiconductrice et dans la mésa, d'une première, une deuxième et une troisième zone semiconductrice, la première zone semiconductrice (10) étant aménagée dans la couche semiconductrice et étant d'un premier type de conductivité et réalisée dans un premier matériau présentant une largeur de bande interdite telle que la première zone semiconductrice (10) est transparente dans la première gamme de longueurs d'onde, la deuxième zone semiconductrice étant d'un deuxième type de conductivité opposé au premier type de conductivité de manière à former une jonction semiconductrice présentant une zone de charge d'espace, la deuxième zone semiconductrice (20) étant réalisée dans un deuxième matériau semiconducteur présentant une largeur de bande interdite adaptée pour favoriser l'absorption du rayonnement électromagnétique, la deuxième zone semiconductrice présentant une concentration en porteurs majoritaires telle que la deuxième zone semiconductrice (20) est comprise dans la zone de charge d'espace, et est donc déplétée en l'absence de polarisation de la structure (1), la troisième zone semiconductrice (30) étant du deuxième type de conductivité et réalisée dans un troisième matériau présentant une largeur de bande interdite telle que la troisième zone semiconductrice (30) est transparente dans la première gamme de longueurs d'onde, ladite troisième zone semiconductrice (30) étant interposée entre la première et la deuxième zone semiconductrice (10, 20) en étant au moins partiellement agencée dans la couche semiconductrice (120) et en formant la jonction semiconductrice avec la première zone semiconductrice (10) dans la couche semiconductrice (120), et dans laquelle la troisième zone semiconductrice (30) forme avec la deuxième zone semiconductrice (20) une barrière de potentiel pour les porteurs minoritaires de la deuxième zone semiconductrice (20).

12. Procédé de fabrication selon la revendication 11, dans lequel lors de l'étape de fourniture du support (100), la couche semiconductrice (120) est réalisée dans un tellurure de mercure cadmium du type CdₓHg₁₋ₓTe, avec x compris entre 0 et 1, 0 et 1 exclus, et présente le premier type de conductivité, le premier type de conductivité étant celui dans lequel les porteurs majoritaires sont des trous, les porteurs majoritaires dans la couche semiconductrice (120) étant principalement fournis par des lacunes de mercure Hg,
et dans lequel l'étape d'aménagement des première, deuxième et troisième zone semiconductrice (10, 20, 30) comprend une sous-étape de diffusion de mercure dans une partie de la couche semiconductrice de manière à venir remplir les lacunes de mercure Hg et neutraliser les trous pour inverser le type de conductivité dans ladite partie de la couche semiconductrice et ainsi former la troisième zone semiconductrice (30), le reste de la couche semiconductrice formant alors la deuxième zone semiconductrice (20).

13. Procédé de formation selon la revendication 12, dans laquelle lors de l'étape d'aménagement des première, deuxième et troisième zone semiconductrice (10, 20, 30), la sous-étape de diffusion consiste en une étape d'implantation ionique de la mésa (130) adaptée pour libérer du mercure Hg.

14. Procédé de fabrication selon la revendication 12, dans laquelle lors de l'étape d'aménagement des première, deuxième et troisième zone semiconductrice (10, 20, 30), la sous-étape de diffusion consiste en une étape de gravure partielle de la mésa (130) adaptée pour libérer du mercure Hg.

15. Procédé de fabrication selon la revendication 12, dans laquelle lors de l'étape d'aménagement des première, deuxième et troisième zone semiconductrice (10, 20, 30), la sous-étape de diffusion consiste en une étape de diffusion thermique de mercure dans la mésa (130).
